# FASCICULE DE BREVET EUROPEEN

(11) **EP 0 504 053 B1**
(45) Date de publication et mention de la délivrance du brevet: **11.01.1995**
(21) Numéro de dépôt: 92400648.9
(22) Date de dépôt: 12.03.1992
(51) Int. Cl.: H01L 21/00

(54) **Conteneur autonome pour le traitement sous vide d'un objet, et son sas de transfert**
Autonomer Behälter für Vakuumsbehandlung eines Objekts und Übertragungsschleuse
Autonomous container for treating an object under vacuum and transfer lock

(30) Priorité: 14.03.1991 FR 9103115
(43) Date de publication de la demande: 16.09.1992
(73) Titulaire: FRANCE TELECOM, 75015 Paris (FR)
(72) Inventeur: Houzay, Françoise, F-92220 Bagneux (FR); Moison, Jean-Marie, F-78290 Croissy sur Seine (FR); Nissim, Yves, F-75020 Paris (FR)
(74) Mandataire: Dubois-Chabert, Guy

(56) Documents cités:
- WO-A-88/09563

## Description

### DOMAINE DE L'INVENTION

L'invention concerne le traitement sous vide d'objets, et en particulier la réalisation de composants électroniques ou micro-électroniques, tels que les circuits intégrés destinés à l'optoélectronique.

### ART ANTERIEUR

La technologie de fabrication des circuits intégrés pour la micro-électronique et l'optoélectronique nécessite un environnement de plus en plus propre, dans le but d'obtenir un rendement de fabrication toujours meilleur. En effet, les composants ne doivent pas être en contact avec des impuretés lors de leur fabrication. De plus, un certain nombre d'entre eux comporte des interfaces aux propriétés optiques et électroniques tellement sensibles, qu'un passage à l'air ambiant, en cours de fabrication, devient problématique. Or, l'élaboration de tels produits entraîne plusieurs étapes technologiques ou d'analyses devant s'effectuer à des postes différents.

Pour éviter que les transferts entre les différents postes s'effectuent à l'air ambiant, une première solution consiste à réduire ces transferts en maintenant sous vide à tout moment, le composant à traiter. Cette solution est mise en oeuvre en connectant les différents postes entre eux, constituant ainsi une unité de travail désignée sous le nom de "machine unique". Cette machine unique est lourde et très peu maniable, compte tenu de la diversité de l'évolution et des conditions de sécurité de chaque poste. De telles machines peuvent occuper une superficie de plusieurs dizaines de mètres carrés.

Une deuxième solution consiste à utiliser le système de "valise" pour transporter, d'un poste à l'autre, l'échantillon à traiter. On connaît ainsi des conteneurs pouvant transporter des échantillons sous vide, et ayant dans ce but une unité autonome de vide. Généralement, l'échantillon transporté est transféré du conteneur vers un poste de travail au moyen d'un sas de transfert.

Le but de l'invention est de fournir un conteneur amélioré permettant à la fois le transfert sous vide d'un échantillon entre deux postes et son transfert dans l'enceinte dudit poste, mais également d'effectuer certaines opérations à partir du conteneur lui-même ou dans le sas de transfert.

D'autre part, dans le document WO-A-8809563 concernant l'implantation ionique, notamment dans la fabrication des semi-conducteurs, on décrit un conteneur et une station de transfert. Le conteneur est équipé de moyens de manipulation des objets à l'intérieur de lui-même et peut être fixé à un sas de transfer fixé à une machine de traitement.

### RESUME DE L'INVENTION

Un premier objet de l'invention est un conteneur autonome pour le transport sous vide, d'un poste à l'autre, d'un objet à traiter au cours d'une série d'opérations, comportant :
- une enceinte de petite taille, munie d'une ouverture pour permettre l'entrée et la sortie de l'objet maintenu sous vide au moyen d'une pompe alimentée par une source d'alimentation autonome ;
- des moyens de manutention de l'objet; et
- des moyens de fixation du conteneur à un sas de transfert de l'objet vers un poste de travail.

Selon l'invention, le conteneur comprend :
- des moyens de traitement de l'objet dans l'enceinte;
- des traversées étanches à travers l'enceinte pour des conducteurs électriques nécessaires aux moyens de traitement. Parmi les traitements envisagés, on englobe les caractérisations électriques ; et
- des hublots transparents de visualisation pour observer et surveiller le déroulement des opérations menées auprès de l'objet dans l'enceinte.

Les hublots permettent, entre autres, d'effectuer des traitements par irradiations lumineuses.

De cette manière, le conteneur sert à la fois au transport et au traitement de l'objet.

L'enceinte du conteneur comporte de préférence une arrivée de gaz, pour permettre un traitement au gaz de l'objet.

Le conteneur se complète avantageusement d'un levier de manipulation de l'objet selon un axe de translation, à une extrémité duquel est fixée une plate-forme de fixation de l'objet, de manière à pouvoir sortir et rentrer selon l'axe de translation et tourner l'objet pour le positionner à l'intérieur et à l'extérieur de l'enceinte.

De manière à permettre le transport sous vide de l'objet, la plate-forme comporte de préférence une base munie de moyens d'étanchéité qui obstrue l'ouverture de l'enceinte lorsque la plate-forme est placée dans l'enceinte pour enfermer l'objet dans celle-ci.

Une réalisation principale du conteneur prévoit que les moyens de traitement sont constitués d'éléments électriques chauffants.

De manière à pouvoir effectuer dans l'enceinte des opérations d'observations optiques spéciales, il est prévu de positionner angulairement au moins un hublot à l'angle de BREWSTER par rapport à la plate-forme, autour de l'axe de translation.

Un deuxième objet principal de l'invention complétant avantageusement le conteneur, est un sas de transfert d'un objet placé dans un conteneur, tel qu'il vient d'être résumé, pour transférer l'objet vers un poste de travail et comprenant :
- une bride de fixation sur un poste de travail ; et
- des moyens de réception du conteneur.

Selon l'invention, ce sas comporte également des hublots de visualisation pour observer l'objet et surveiller le déroulement des opérations menées auprès de l'objet dans le sas.

Ce sas est avantageusement équipé d'une canne de transfert pour faire passer l'objet de la plate-forme du conteneur, lorsqu'il est sorti, dans le poste de travail, quand le sas est fixé auprès de ce dernier.

### LISTE DES FIGURES

L'invention et ses différentes caractéristiques techniques seront mieux comprises à la lecture de la description suivante, donnée à titre explicatif mais non limitatif et annexée des figures représentant respectivement :
- figure 1, en coupe, l'assemblage du conteneur et du sas selon l'invention ;
- figure 2, en coupe, le conteneur selon l'invention en position fermée ;
- figure 3, vue de dessus du conteneur seul ; et
- figure 4, la vue de dessus correspondant à la figure 3 représentant le conteneur et le sas.

### DESCRIPTION DETAILLEE D'UNE REALISATION DE L'INVENTION

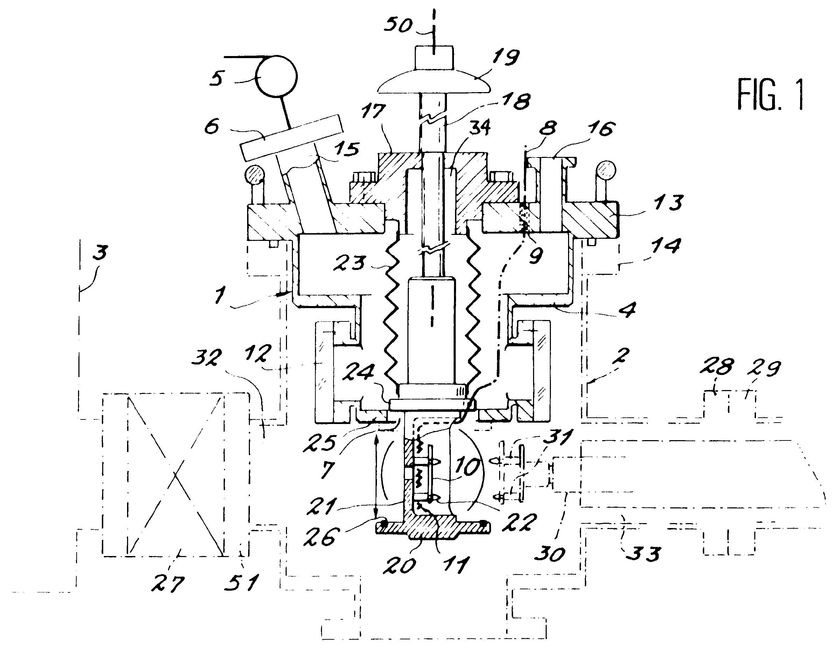

La figure 1 décrit le conteneur 1 placé sur un sas 2, cet ensemble étant fixé à l'entrée d'un poste de travail 3. Le conteneur 1 est constitué principalement d'une enceinte étanche 4 dans laquelle le vide peut être fait au moyen d'une pompe 5 fixée par l'intermédiaire d'une bride 6.

Le caractère portatif du conteneur 1 impose que l'enceinte 4 soit de petite taille et que la pompe 5 soit légère. Elle doit néanmoins permettre d'obtenir un vide propre et élevé à l'intérieur de l'enceinte 4 et avoir une autonomie d'alimentation, donc d'avoir une faible consommation.

Dans le cadre de l'application de l'invention à la fabrication ou la construction d'un composant de micro-électronique, il est préférable d'utiliser une pompe du type ionique, avec une vitesse de pompage avoisinant les dix litres par seconde. La pompe 5 doit disposer de batteries et d'un convertisseur haute tension et avoir une consommation ne dépassant pas dix milliwatts. Ce type de pompe est au catalogue de nombreux constructeurs, dont Méca 2000. La consommation indiquée ci-dessus impose que la pompe fonctionne seulement en régime stationnaire pendant le transport du conteneur. Le démarrage de la pompe 5 est alors assuré par une alimentation classique sur secteur beaucoup plus puissante.

Dans la partie inférieure de l'enceinte 4 est prévue une ouverture 7 pour permettre l'entrée et la sortie dans le conteneur 1 d'un objet, tel qu'un échantillon de circuit de micro-électronique 10. L'entrée et la sortie de ce dernier se fait à l'aide de moyens de manutention qui seront décrits ultérieurement.

Selon l'invention, on prévoit des moyens de traitement de l'objet 10 à l'intérieur de l'enceinte 4. Parmi un des traitements envisagés, on note le chauffage de l'échantillon 10. On peut également citer le traitement de cet échantillon 10 par des gaz et par irradiations lumineuses.

Un traitement consistant à chauffer l'échantillon 10 nécessite l'apport d'énergie électrique à l'intérieur de l'enceinte 4. A cet effet, on prévoit des conducteurs électriques 8 pénétrant dans l'enceinte 4 par au moins une traversée étanche 9 pouvant ainsi alimenter un élément chauffant 11 placé à proximité de l'échantillon 10.

Dans le but de mener à bien ces différentes opérations sur l'échantillon 10 à l'intérieur de l'enceinte 4, il est nécessaire de pouvoir surveiller ce qui se passe à l'intérieur de cette enceinte 4. Selon l'invention, on équipe la partie latérale de l'enceinte 4 de plusieurs hublots 12 de visualisation. Ces hublots 12 permettent ainsi d'observer l'objet 10, quand il est enfermé dans l'enceinte 4, et de procéder également à des opérations optiques sur cet échantillon 10. Un exemple, d'une telle opération, est décrit plus loin dans la description.

Les hublots 12 peuvent être prévus transparents à d'autres longueurs d'onde que les longueurs d'onde visibles.

Le conteneur selon l'invention est de préférence en acier inoxydable.

Le positionnement du conteneur 1 sur le sas 2 impose bien entendu la présence de moyens de fixation sur le sas 2. A cet effet, l'enceinte 4 possède une bride supérieure 13 permettant de prendre appui sur une portée d'appui 14 du sas 2.

Il est prévu également que les moyens de manutention de l'objet 10 soient fixés sur cette bride supérieure 13. On prévoit, à cet effet, un trou central 34 dans la bride supérieure 13, sur lequel peut prendre appui une bague 17 supportant un levier de manutention 18.

Dans la réalisation préférentielle de l'enceinte 4, la mise sous vide et l'arrivée de gaz spéciaux se font par l'intermédiaire de deux canalisations respectives 15 et 16.

Comme le représente cette figure 1, le levier de manutention 18 est monté coulissant dans la bague 17 selon un axe vertical 50 de translation. Il est manipulé à l'aide d'une poignée de manutention 19. Sa translation est verticale lorsque le conteneur 1 est posé sur le sas 2. Une telle translation verticale permet de sortir un objet 10 placé à l'extrémité inférieure du levier 18 et de le placer au milieu du volume resté libre dans le sas 2.

Un soufflet métallique 23 entoure le levier 18 et est fixé de manière étanche par ces deux extrémités, à la fois à la bague 17 et à une portée 24 du levier placé juste au-dessus de la partie verticale 21.

Lorsque le levier 18 est descendu, c'est-à-dire que l'échantillon 10 est sorti de l'enceinte 4, la portée 24 vient prendre appui sur la surface inférieure 25 de l'enceinte 4 et détermine ainsi la position de sortie de l'objet 10. Par contre, lorsque ce dernier est remonté à l'intérieur de l'enceinte au moyen du levier 18, la base 20 prend appui sur la paroi inférieure 25 et ferme ainsi le trou d'accès 7 de l'enceinte 4, de manière étanche, au moyen d'au moins un joint d'étanchéité 26 qui se trouve aller en contact à la fois avec la base 20 et la partie 25 de l'enceinte 4. L'étanchéité au vide et aux éventuels gaz introduits à l'intérieur de l'enceinte, est ainsi assurée complètement.

La fixation de l'objet 10 se fait de préférence sur une plate-forme 20 ou sur une partie verticale 21 supportant la plate-forme 20. Dans la réalisation représentée sur cette figure, l'objet est fixé à la partie verticale 21. Il s'agit ici d'un échantillon de circuit micro-électronique monté sur un porte-échantillon comportant six trous espacés les uns des autres angulairement de 60°. Par ailleurs et en correspondance, la partie verticale 21 possède trois broches horizontales placées angulairement à 120° les unes par rapport aux autres. L'échantillon 10 est fixé par l'introduction des trois broches 22 introduites dans trois des six trous du porte-échantillon.

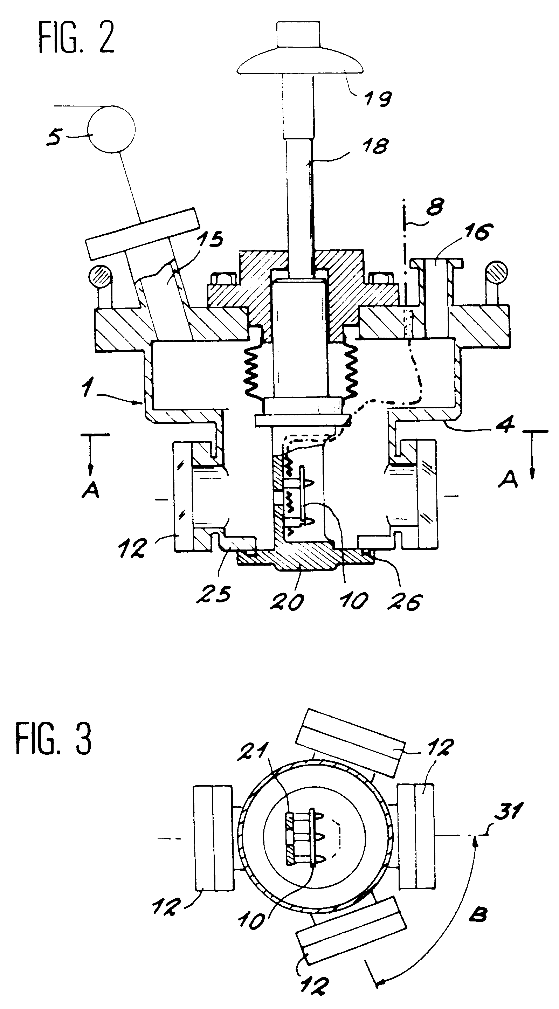

Le conteneur est représenté seul sur la figure 2 et en position fermée, c'est-à-dire que son ouverture inférieure 7 est obstruée par la base de la plate-forme (20). Le levier 18 est remonté au moyen de la poignée 19. L'objet 10 se trouve alors confiné à l'intérieur de l'enceinte étanche 4. Le vide peut alors être fait au moyen de la pompe 5, par l'intermédiaire de la canalisation de gauche 15. Des gaz spéciaux, au traitement de l'objet, peuvent également être introduits au moyen de la canalisation droite 16.

La figure 3 est une coupe suivant la ligne A-A de la figure 2, à travers la partie inférieure du conteneur. Sur cette figure, on peut distinguer l'emplacement spécial des hublots 12 dans une réalisation possible du conteneur selon l'invention. En effet, pour procéder à certaines opérations optiques, telles que la spectrométrie, il s'avère intéressant de positionner au moins un des hublots 12 à un angle déterminé qui est l'angle de réflexion de BREWSTER.

Dans le cas de la présente réalisation, cet angle de BREWSTER B est voisin de 70° par rapport à l'axe d'observation 31 ou de réflexion normale. Un deuxième hublot peut également être disposé angulairement à l'angle de BREWSTER B, de l'autre côté de l'axe de réflexion normale 31.

En revenant à la figure 1, le sas 2 possède plusieurs issues. Sur la gauche, une première issue 32 consiste en une bride de sortie 51 destinée à être fixée sur une vanne 27 permettant l'accès à un poste de travail 3. L'échantillon 10 peut alors être amené à ce poste de travail 3 pour y subir une ou plusieurs opérations de fabrication. La translation horizontale de l'échantillon 10 se fait de préférence au moyen d'une canne de manipulation 30 placée horizontalement en regard de cette première issue 32 dans une canalisation de manipulation 33. Un tel outillage se trouve couramment dans le commerce sous le nom de canne mécanique à guide à billes, et plus particulièrement, est commercialisé par MECA 2 000. Elle permet un déplacement horizontal de cinq cents millimètres.

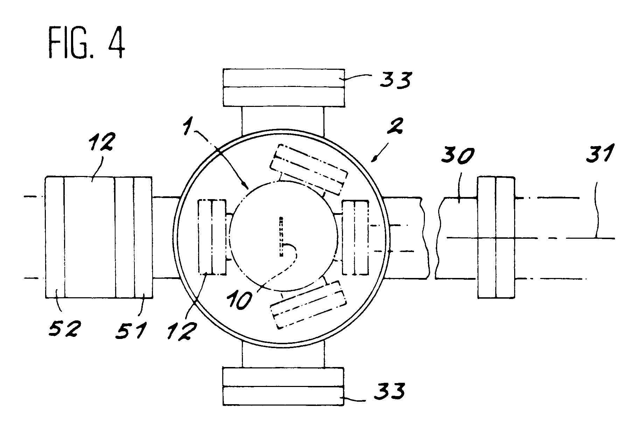

Comme le montre la figure 4, deux hublots latéraux 33 peuvent être placés sur le sas de manière à pouvoir également surveiller et procéder à des opérations optiques à l'intérieur du sas 2 et à l'extérieur du conteneur 1.

Un exemple d'opération optique, pouvant être effectuée à l'intérieur du conteneur 1, est la spectrométrie infrarouge.

Il est également possible de procéder à des analyses de nature électrique, telles que la mesure de caractéristiques électriques à partir du "courant échantillon".

D'autres opérations optiques peuvent être effectuées avec le conteneur 1 et sans le sas 2. On peut citer par exemple, la photoluminescence de la température ambiante à la température de l'azote (cartographie de rendement, spectrométrie, mesure du déclin), la spectroscopie RAMAN, la spectroscopie infrarouge à transformée de FOURIER, les mesures électriques. Toutes ces techniques permettent en particulier le suivi in situ des croissances, c'est-à-dire des dépôts, d'un circuit de micro-électronique.

Les opérations à effectuer sous vide, c'est-à-dire à partir du conteneur 1 et du sas 2, sont par exemple la microscopie électronique, le masquage électronique, l'implantation ionique où le conteneur à un rôle de four de recuit sous atmosphère contrôlée. Par contre, le conteneur 1 peut jouer le rôle de chambre à plasma.

Un exemple plus précis d'application peut être donné. Il s'agit de la fabrication d'une structure pour un composant micro-optoélectronique et comportant une hétérostructure III-V, des couches de passivation et des contacts MIS, MES ou ohmiques. Un tel procédé comprend des étapes qui peuvent être les suivantes :
- fabrication de l'hétérostructure dans un bâti d'épitaxie par jets moléculaires ou autres (jets chimiques, MOCVD ) ;
- transfert vers le conteneur portable ;
- dépôt de diélectrique avec ou sans métal dans le conteneur 1 ;
- transfert vers un bâti d'implantation ou de gravure ou autre ; et
- retour vers le conteneur portable 1 pour analyse et poursuite du processus.

D'autre part, on peut procéder à tout moment à l'une des deux opérations suivantes :
- caractérisation, par exemple par spectrométrie AUGER dans un bâti d'analyse ; et
- caractérisation in situ dans le conteneur, par exemple, par spectrométrie infrarouge, photoluminescence.

Parmi les avantages procurés par l'invention, on peut citer :
- gain sur la qualité de l'échantillon et des interfaces entre les différentes couches. En effet, l'échantillon 10 est conservé sous vide, ce qui évite la formation d'oxyde natif. Or, la surface d'une hétérostructure du type III-V ainsi contaminée doit être nettoyée chimiquement avant le dépôt de la couche suivante. Cette opération est longue, compliquée et n'est jamais parfaitement réalisée, la surface ayant toujours le temps de se contaminer avant l'introduction dans le bâti de traitement ;
- gain du coût et de la sécurité d'installation par remplacement de la machine du type "unique", très volumineuse, onéreuse et nécessitant la présence au même endroit de tous les bâtis nécessaires à chaque opération du processus. Des problèmes de sécurité concernant l'arsenic et les hydrures apparaissent. Chaque bâti doit avoir un sas personnalisé ;
- le processus de fabrication est mieux suivi. En effet, à chaque étape, les échantillons peuvent être analysés par les différentes techniques électroniques et optiques sans dégradation de cet échantillon ; et
- le conteneur selon l'invention permet également de faciliter le stockage de plusieurs échantillons dans un bâti en plein milieu du processus de fabrication, de manière à constituer des lots.

La réalisation qui vient d'être décrite n'est qu'un exemple de ce qui peut être mis en oeuvre. En effet, les positions des vannes et des différents accès aux postes de travail peuvent être très différentes et nombreuses sans pour cela changer la conception du conteneur selon l'invention.

## Revendications

1. Conteneur (1) autonome pour le transport sous vide d'un poste à un autre d'un objet (10) à traiter au cours d'une série d'opérations, comportant :
- une enceinte (4) de petite taille, possédant une ouverture (7) pour permettre l'entrée et la sortie de l'objet (10) et maintenue sous vide au moyen d'une pompe (5) alimentée par une source d'alimentation autonome ;
- des moyens de manutention de l'objet (10); et
- des moyens de fixation du conteneur (1) à un sas (2) de transfert de l'objet (10) vers un poste de travail (3),
caractérisé en ce qu'il comprend :
- des moyens de traitement de l'objet (10) dans l'enceinte (4);
- au moins une traversée étanche (7) à travers l'enceinte (4) pour permettre à au moins un conducteur électrique (8) nécessaire aux moyens de traitement de traverser l'enceinte (4) ; et
- des hublots (12) de visualisation, transparents à certaines longueurs d'onde, pour observer l'objet (10) et surveiller le déroulement des opérations menées auprès de cet objet (10) dans l'enceinte (4).

2. Conteneur (1) selon la revendication 1, caractérisé en ce qu'il comprend au moins une arrivée de gaz (16) dans l'enceinte (4).

3. Conteneur (1) selon la revendication 1 ou 2, caractérisé en ce qu'il comprend un levier de manipulation (18) selon un axe de translation (50), à une extrémité duquel est fixée une plate-forme de fixation (20, 21) de l'objet (10) pour sortir et rentrer selon l'axe de translation (50) et tourner l'objet (10) afin de le positionner à l'intérieur et en dehors de l'enceinte (4).

4. Conteneur (1) selon la revendication 3, caractérisé en ce que la plate-forme (20, 21) à une base (20) munie de moyens d'étanchéité (26) qui obstrue l'ouverture (7) de l'enceinte (4) lorsque la plate-forme (20, 21) est placée dans l'enceinte (4) pour enfermer l'objet (10) dans celle-ci et permettre le transport sous vide de cet objet (10).

5. Conteneur (1) selon l'une quelconque des revendications précédentes, caractérisé en ce les moyens de traitement sont constitués d'au moins un élément électrique chauffant (11), d'une entrée de gaz et de facilités pour irradiations lumineuses.

6. Conteneur (1) selon l'une quelconque des revendications précédentes, caractérisé en ce qu'au moins un hublot (12) est positionné angulairement à l'angle de BREWSTER relatif à l'objet (10), autour de l'axe de translation (50) par rapport à la plate-forme (20, 21).

7. Sas (2) de transfert d'un objet (10) placé dans un conteneur (1) selon l'une quelconque des revendications précédentes vers un poste de travail (3) de l'objet (10), comportant :
- une bride de fixation (51) sur le poste de travail (3) ; et
- des moyens de réception (14) du conteneur (2), caractérisé en ce qu'il comprend des hublots de visualisation (33) pour observer l'objet (10) et surveiller le déroulement des opérations menées auprès de cet objet (10) dans le sas (2).

8. Sas (2) selon la revendication 7, caractérisé en ce qu'il comprend une canne de manipulation (30) pour faire passer l'objet (10) de la plate-forme (20, 21) du conteneur (1) lorsqu'elle est sortie dans un poste de travail (3) quand le sas (2) est fixé auprès de ce dernier.

## Patentansprüche

1. Unabhängiger Behälter (1) für den Transport eines Objektes (10) unter Vacuum von einem Platz zum anderen, wobei das Objekt während des Ablaufes einer Reihe von Arbeitsvorgängen unterzogen wird, mit
- einem Gefäß (4) von geringer Größe, welches eine Öffnung (7) besitzt, um den Eintritt sowie das Verlassen des Objektes (10) zu ermöglichen und unter Vakuum gehalten ist, durch eine Pumpe (5), welche durch eine autonome Versorgungsquelle gespeist wird;
- eine Einrichtung zum Handhaben des Objektes (10), und mit einer Einrichtung zur Befestigung des Behälters (1) an einer Schleuse (2) für die Übergabe des Objektes (10) an einen Arbeitsplatz (3);
**dadurch gekennzeichnet,** daß er
- eine Einrichtung zur Behandlung des Objektes (10) in dem Gefäß (4);
- das mindestens eine dichte Durchführung (7) durch das Gefäß (4), um die Durchführung mindestens eines elektrischen Leiters (8), für die Behandlungseinrichtung notwendig ist, durch das Gefäß (4) zu ermöglichen; und
- Bullaugen (12) zur Sichtbarmachung aufweist, die für bestimmte Wellenlängen transparent, um das Objekt (10) zu beobachten und den Fortgang der Arbeitsvorgänge zu überwachen, die an dem Objekt (10) in dem Gefäß (4) vorgenommen werden.

2. Behälter (1) nach Anspruch 1, **dadurch gekennzeichnet,** daß er mindestens einen Gasanschluß (16) im Gefäß (4) beinhaltet.

3. Behälter (1) gemäß Anspruch 1 oder 2, **dadurch gekennzeichnet,** daß er einen Hebel zur Manipulation (18) gemäß einer Translationsachse (50) umfaßt, an dessen einem Ende eine Fixierungsplattform (20, 21) des Objektes (10) befestigt ist, um gemäß der Translationsachse (50) das Objekt heraus- und hereinnehmen sowie drehen zu können, um es im Inneren sowie außerhalb des Gefäßes (4) positionieren zu können.

4. Behälter (1) gemäß Anspruch 3, **dadurch gekennzeich****net**, daß die Plattform (20, 21) eine Basis (20) mit Dichtungsmitteln (26) aufweist, welche die Öffnung (7) des Gefäßes (4) verschließen, wenn die Plattform (20, 21) in dem Gefäß (4) plaziert ist, um das Objekt (10) darin einzuschließen und den Transport dieses Objektes (10) unter Vakuum zu erlauben.

5. Behälter (1) gemäß einem der vorhergehenden Ansprüche, **dadurch gekennzeichnet,** daß die Behandlungseinrichtung aus mindestens einem elektrischen Heizelement (11), einem Gaseintritt und Einrichtungen zur Lichtbestrahlung gebildet ist.

6. Behälter (1) gemäß einer der vorhergehenden Ansprüche, **dadurch gekennzeichnet**, daß mindestens ein Bullauge (12) in einem Winkel, um die Achse der Translation (50) in bezug auf die Plattform (20, 21), entsprechend dem Brewster-Winkel relativ zum Objekt (10) positioniert ist.

7. Schleuse (2) für den Transfer eines Objektes (10), der in einem Behälter (1) gemäß einem der vorhergehenden Ansprüche angeordnet ist, an einen Arbeitsplatz (3) des Objektes (10), mit:
- einem Flansch zur Fixierung (51) an dem Arbeitsplatz (3); und
- einer Einrichtung zur Aufnahme (14) des Behälters (2), **dadurch gekennzeichnet**, daß sie Bullaugen zur Sichtbarmachung (33) umfaßt, um das Objekt (10) beobachten und den Fortgang der Arbeitsvorgänge, die an diesem Objekt (10) in der Schleuse (2) ausgeführt werden, überwachen zu können.

8. Schleuse (2) gemäß Anspruch 7, **dadurch gekennzeichnet**, daß sie ein Rohr zur Manipulation (30) umfaßt, um das Objekt (10) von der Plattform (20, 21) des Behälters (1) passieren zu lassen, wenn es einen Arbeitsplatz (3) verlassen hat, wenn die Schleuse (2) an diesem letzten fixiert ist.

## Claims

1. Autonomous container (1) for the vacuum transportation from one station to another of an object (10) to be treated during a series of operations comprising a small enclosure (4) having an opening (7) for the introduction and removal of the object (10) and kept under a vacuum by means of a pump (5) supplied by an autonomous supply source, means for handling the object (10) and means for fixing the container (1) to a lock (2) for the transfer of the object (10) to a working station (3), characterized in that it comprises means for treating the object (10) in the enclosure (4), at least one tight bushing (7) through the enclosure (4) to permit the passage through the latter of at least one electrical conductor (8) required by the treatment means and viewing shielding windows (12) transparent to certain wavelengths for observing the object (10) and for monitoring the performance of the operations around said object (10) in the enclosure (4).

2. Container (1) according to claim 1, characterized in that it has at least one gas intake (16) in the enclosure (4).

3. Container (1) according to claims 1 or 2, characterized in that it has a handling lever (18) along a translation axis (50), to one end of which is fixed a platform (20, 21) for the object (10) for the removal, return and turning of the object (10) along the translation axis (50), in order to position it inside and outside the enclosure (4).

4. Container (1) according to claim 3, characterized in that the platform (20, 21) has a base (20) equipped with sealing means (26), which close the opening (7) of the enclosure (4) when the platform (20, 21) is placed in the enclosure (4) in order to contain the object (10) therein and to permit the vacuum transportation of said object (10).

5. Container (1) according to any one of the preceding claims, characterized in that the treatment means are constituted by at least one electric heating element (11), a gas intake and visible radiation facilities.

6. Container (1) according to any one of the preceding claims, characterized in that at least one shielding window (12) is positioned angularly at a Brewster angle relative to the object (10), about the translation axis (50) with respect to the platform (20, 21).

7. Transfer lock (2) for an object (10) placed in a container (1) according to any one of the preceding claims to a working station (3) for the object (10) and comprising a fixed flange (51) on the working station (3) and reception means (14) for the container (1), characterized in that it has viewing windows (33) for the observation of the object (10) and for the monitoring of the performance of the operation carried out around the object (10) in the lock (2).

8. Lock (2) according to claim 7, characterized in that it has a handling rod (30) for passing the object (10) from the platform (20, 21) of the container (1) when removed into a working station (3) when the lock (2) is fixed round the latter.
